# EUROPEAN PATENT APPLICATION

(11) **EP 1 065 752 A1**
(43) Date of publication of application: **03.01.2001**
(21) Application number: 99480054.8
(22) Date of filing: 01.07.1999
(51) Int. Cl.: H01R 12/18

(54) **Dual slots dimm socket with right angle orientation**

(71) Applicant: International Business Machines Corporation, Armonk, N.Y. 10504 (US)
(72) Inventor: Klein, Philippe, 06610 La Gaude (FR)
(74) Representative: Etorre, Yves Nicolas

(57) **Abstract**

The present invention is directed to a system for increasing the memory cards (DIMM) density in an electronic blade where problem of thickness is a major concern. This is done thanks to a dual slot right angle DIMM socket that combines small thickness due to right angle orientation and high density due to the two DIMMs slots.

## Description

### Technical field of the invention

The present invention relates to personal computers, telecommunication and networking devices using DRAM DIMM (Dynamic Random Access Memory Dual In line Memory Module) memory cards, and more particularly to a system for increasing memory cards density and limiting capacitive effect on electronic boards.

### Background art

### DRAM DIMMs

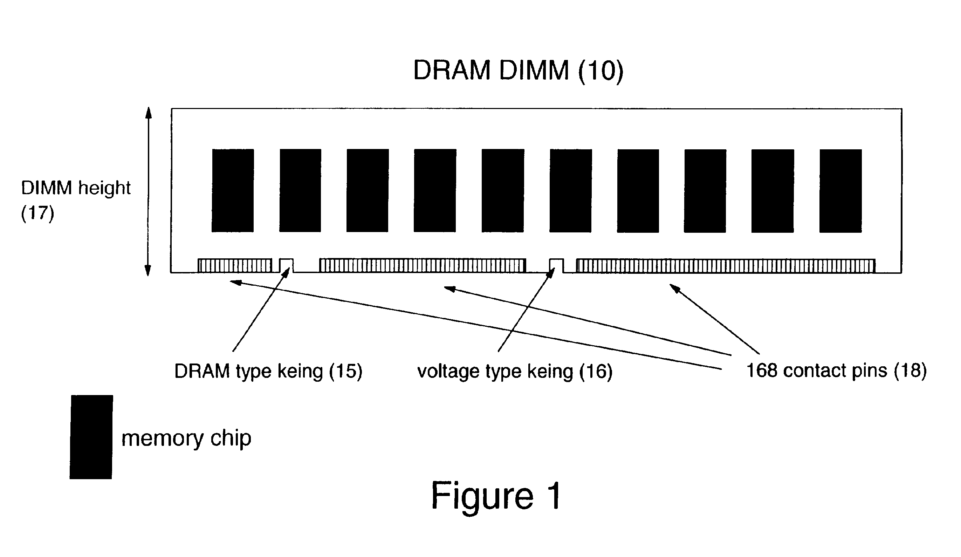

DRAM DIMMs (10) - Dynamic Random Access Memory Dual In line Memory Modules - are memory cards intended to be connected on an electronic board (22, 32, 42, 72, 92) to provide additional memory capacity. As shown in Figure 1, the main features are the following:
- a 8-bytes data bus,
- a capacity ranging from few Mbytes to several hundred of Mbytes,
- a standard form factor with 168 contact pins (18, 68, 88), and
- an operating frequency reaching 133MHz.

An advanced two-keys design provides both damage protection for various voltages (16) and DRAM types (15).

### DRAM Sockets

The connection of a DRAM DIMM (10) on an electronic board (22, 32, 42, 72, 92) is performed thanks to a DIMM connector called DIMM socket (21, 31, 41, 61, 71) which is itself soldered on the electronic board. DIMM sockets are intended to house 8-bytes DRAM DIMMs (10). They are designed for 168-contact pins DIMM per JEDEC Standard MO-161 and can accept Standard DRAM, Synchronous DRAM (SDRAM) and Non-Standard (Non-buffered) DRAM modules in 5-volts, 3.3-volts and future X.X-volts versions. Sockets have been designed to be low cost and highly reliable and to save space.

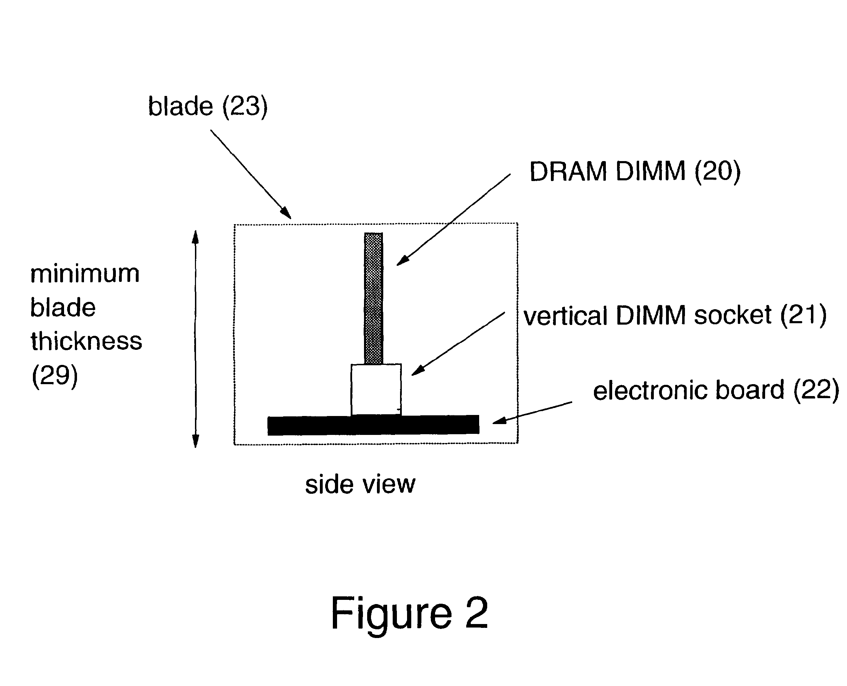

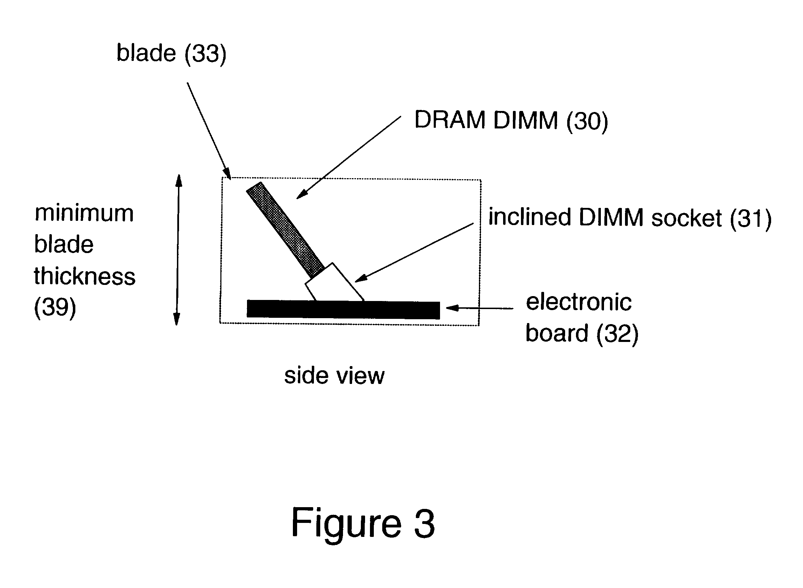

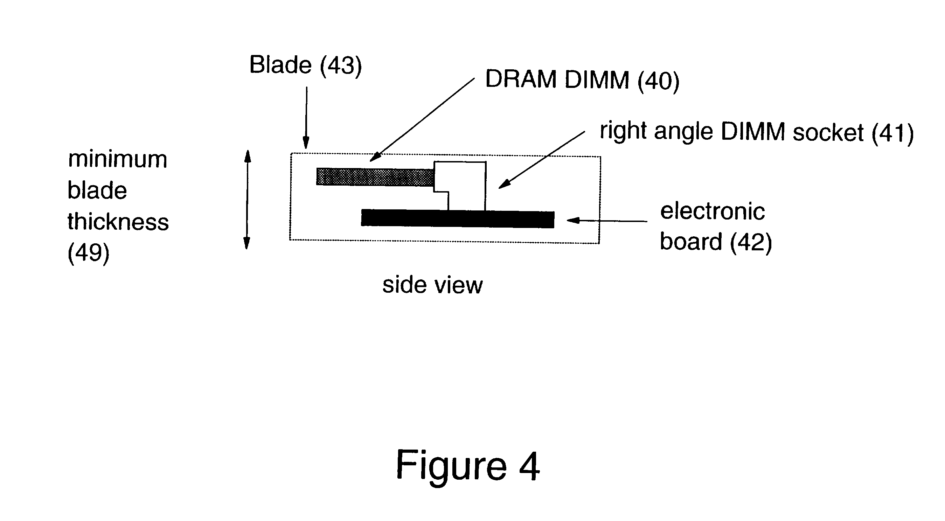

The combination of DIMM sockets (21,31,41,61,71) and DIMMs (10) provides an ideal solution for today's high-end personal computers and workstations. Three kinds of DIMM sockets are available today :
- Vertical DIMM socket (21): As shown in Figure 2, the DRAM DIMM (20) is plugged perpendicularly to the electronic board (22). The thickness (29) of the blade (23) (name given to the packaging that encapsulates the board) must be at least equal to the height of the DRAM DIMM plus the DRAM socket. This solution is used with standard personal computers and workstations where there is no problem of blade thickness.
- Inclined DIMM socket (31): As shown in Figure 3, the DRAM DIMM (30) is plugged with an angle of 22° to 40° in the electronic board (32). This solution is used in standard portable personal computers and in telecommunication and networking devices when the problem of blade thickness (39) does not allow the use of vertical DIMM sockets.
- Right angle socket (41) : As shown in Figures 4, the DRAM DIMM (40) is plugged with an angle of 180° in the electronic board (42) and is so connected horizontally on the board allowing to get rid of the problem of blade thickness (49). This last solution is more particularly used in specific portable personal computers and in specific telecommunication and networking devices where the blade thickness is a critical factor.

### Problem

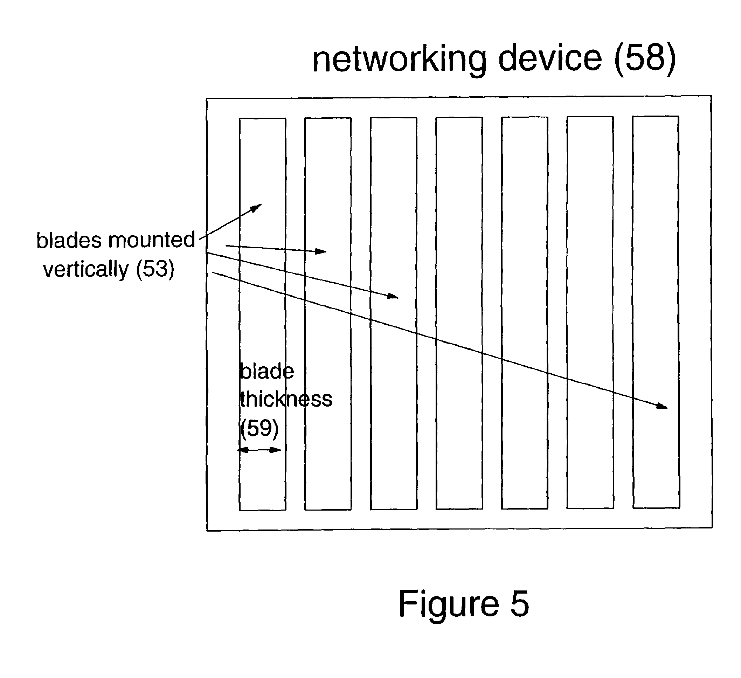

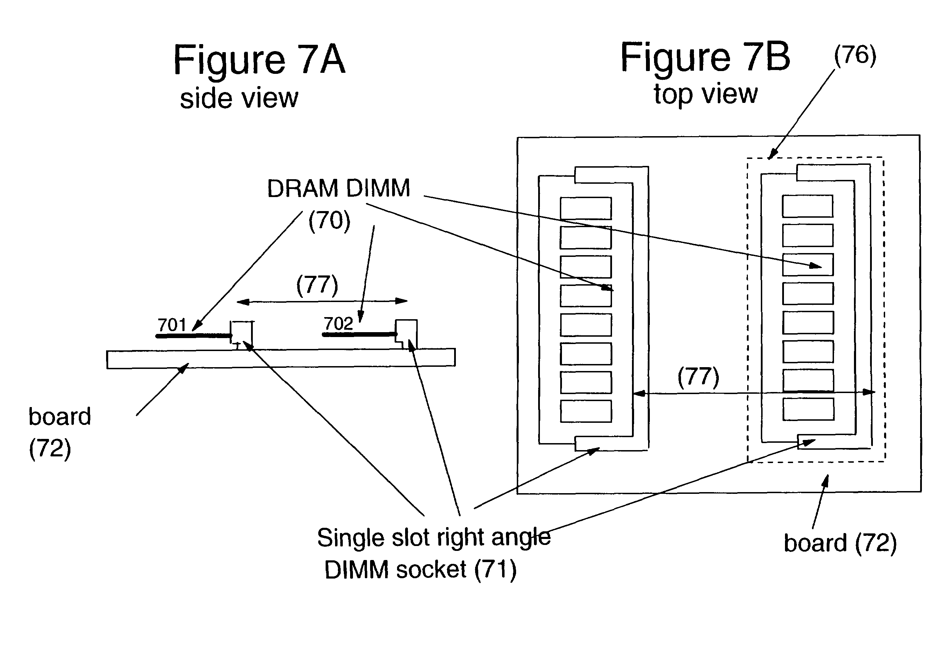

As shown in Figure 5, blades (53) that hold electronic cards are generally plugged vertically into the telecommunication or networking devices (58) and have a thickness (59) of few millimeters (20.00 mm for instance in the CompactPCI standard). DRAM DIMMs are higher (17) (from 35.00 mm to 45.00 mm for 512 MBytes DRAM DIMM) forcing card designers to use right angle sockets (41,61,71). As shown in Figure 7, when several DIMMs (70) are required on an electronic board (to increase the memory capacity for instance), the space lost on the board (72) becomes rapidly very important. As shown in Figure 7, because a DIMM is inserted horizontally into the socket, it is necessary to reserve enough free space between two sockets (77) (at least one DIMM height) in order to be able to plug one DIMM (702) easily without being disturbed by the other DIMM (701) socket. Furthermore, the capacitive effect increases significantly due to the distance (77) between the DIMM sockets (71).

### Summary of the invention

The object of the present invention is to save space, reduce thickness and limit capacitive effect on electronic boards comprising a plurality of DRAM DIMMs. The present invention discloses a dual slots right angle socket for connecting two DRAM DIMMs with only one 168 contact pin footprint on the electronic board and with a height smaller than inclined or vertical DIMM sockets.

The main advantage of the dual slots right angle socket is to double the DIMMs density on electronic boards.

A second advantage is to reduce the thickness of electronic boards comprising DRAM DIMMs.

A third advantage is to limit the distance between DRAM DIMMs on an electronic board.

### Drawings

The novel and inventive features believed characteristics of the invention are set forth in the appended claims. The invention itself, however, as well as a preferred mode of use, further objects and advantages thereof, will best be understood by reference to the following detailed description of an illustrative detailed embodiment when read in conjunction with the accompanying drawings, wherein :
- Figure 1 shows a general view of a Dynamic Random Access Memory Dual In line Memory Module (DRAM DIMM).
- Figure 2 is a side view of a vertical DIMM socket on an electronic board.
- Figure 3 is a side view of an inclined DIMM socket on an electronic board.
- Figure 4 is a side view of a right angle DIMM socket on an electronic board.
- Figure 5 is a general view of a device comprising vertical blades.

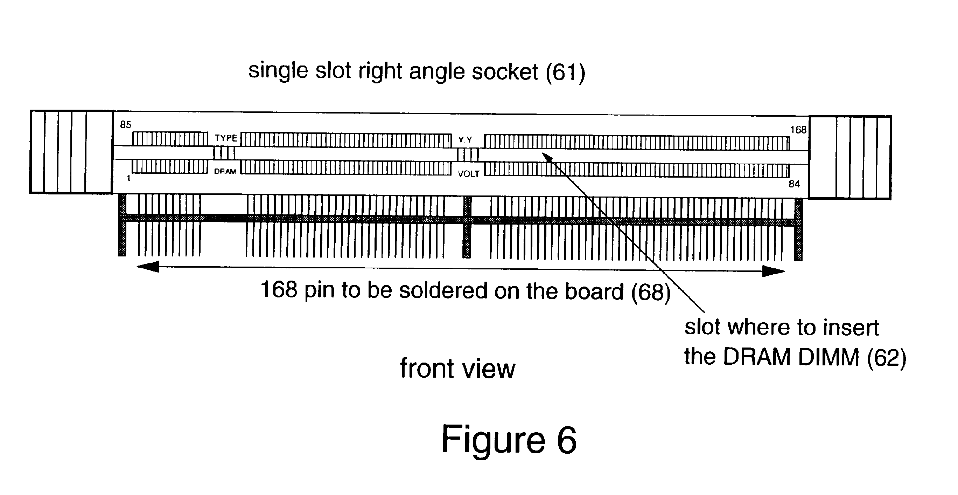

- Figure 6 is a front view of a standard single slot right angle DIMM socket.
- Figure 7A is a side view of two single slot right angle sockets on an electronic board according to prior art.
- Figure 7B is a top view of two single slot right angle sockets on an electronic board according to prior art.
- Figure 8 is a front view of a dual slots right angle DIMM socket according to the present invention.

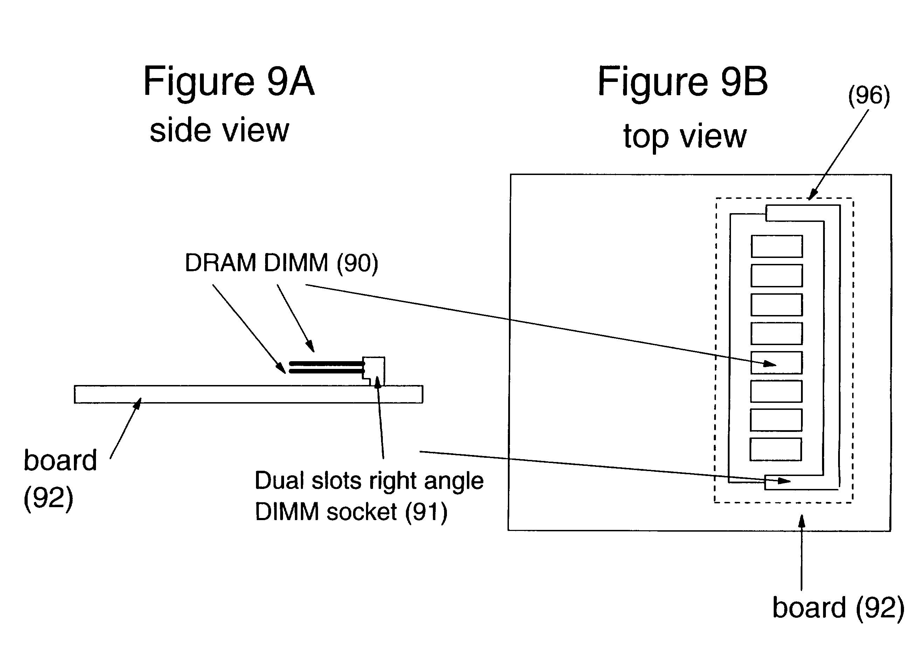

- Figure 9A is a side view of a dual slots right angle socket on an electronic board according to the present invention.
- Figure 9B is a top view of a dual slots right angle socket on an electronic board according to the present invention.

### Preferred embodiment of the invention

The present invention is directed to a system for increasing the memory cards density in an electronic blade where the problem of thickness is a major concern. This is done thanks to a dual slot right angle DIMM socket that combines small thickness due to right angle orientation and high density due to the two DIMMs slots.

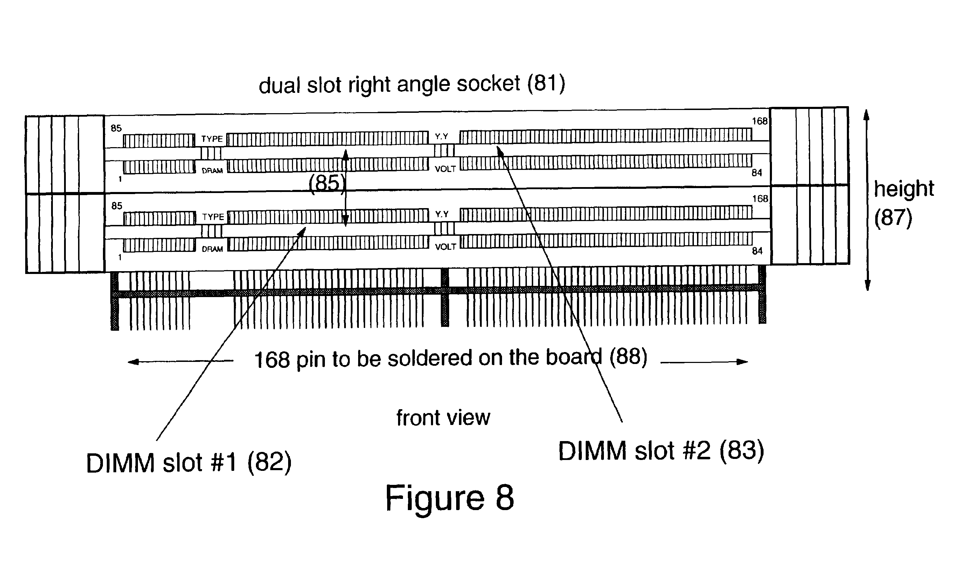

As shown in Figure 8, the dual slots right angle socket (81) according to the present invention provides two DRAM DIMM slots (82 and 83) very close together. Both slots are connected to a single 168-contact pins footprint (88) identical to the 168-contact pins footprint (68) of a standard single slot right angle DIMM socket. With this arrangement, the space (96) occupied on the electronic board is the same than the space used by a single slot DRAM DIMM (76) as shown in Figure 7.

The distance between the two DRAM DIMMs is reduced to a minimum (85) and so there is no additional PCB (Printed Circuit Board) trace length between both DRAM DIMMs on the board as it is with single slot right angle DIMM sockets (77). This configuration reduces the capacitive effect and thus improves the quality of the data transmission :
- When two DRAM DIMMs are very close together, the connection between the memory controller and the two DRAM DIMMs is seen as a point to point connection (single PCB trace length) loaded by an equivalent capacitive load of twice the capacitive load of a one DRAM DIMM. The point to point connection is the best arrangement to optimize the line transmission because the line adaptation to avoid signal reflection is easily performed.
- When two DRAM DIMMs are separated from several centimeters one from the other, the connection between the memory controller and the two DRAM DIMMs is seen as a point to multipoint connection. Each DRAM DIMM is considered as one point with its own capacitive load plus the capacitive load of the PCB trace length and the line adaptation is more difficult to perform.

Among the 168-contact pins (88) of the dual slots DIMM socket:
- Most of signals are common to the two DIMM slots :
   Address (A[0:13]), Data (DQ[0:63]), Check Bits (CB[0:7]), Write Enable (WE), Byte Enable (DQM[0:7]), Clock Enable (CKE0) , Clock (CLK[0:3]) , Row Address Strobe (RAS), Column Address Stobe (CAS), Bank Address (BA[0:1]),Serial data I/O (SDA), Serial Clock (SCL), Register Enable (REGE) Power Supply (VDD) and Ground (VSS).
   "Commons" means that whatever the DIMM accessed (DIMM#1 or DIMM#2) all these signals are driven to both DIMMs. The selection of one DIMM among the two is done thanks to specific DIMM signals as described hereafter.
- Specific signals are dedicated to one and only one DIMM slot :
   - Chip Select signals : CS[0:3]#1 is dedicated for DIMM slot #1 and CS[0:3]#2 is dedicated for DIMM slot #2. These signals allow the DRAM memory controller to select only one DIMM at the time (CS#1 and CS#2 can not be active at the same time).
   - Serial Address signals : SA[0:2]#1 is dedicated for DIMM slot #1 and SA[0:2]#2 is dedicated for DIMM slot #2. These signals give the address of the serial ROM (Read Only Memory) located on each DIMM (the serial ROM contains the vital Product Data of the DIMM like memory size, timings, manufacturer, ....)

These specific signals CS[0:3]#2 and SA[0:2]#2 are added on top of the standard 168 pin assignment and take the location of unused pins (referred as Not Connected).

Table 1 in the annex of the present description gives the 168-pin assignment of the standard single slot DIMM socket. Table 2 gives the new 168-pin assignment of the Dual slots right angle DIMM socket.

The pin assignment allows an easy replacement of :
1. A dual slots right angle DIMM socket by a single slot right angle DIMM socket without any change
2. A single slot right angle DIMM socket by a dual slots right angle DIMM socket with only seven wires to add (four wires for CS[0:3]#2 and tree wires for SA[0:2]#2).

The concept of dual slots right angle DRAM DIMM socket is easily applicable to other kind of memory (SRAM , FLASH RAM, ...) , in that case SA[0:2] signals will remain unused as they are present only on DRAM DIMM type memories.

**Note** : The Dual slots vertical DRAM DIMM socket is not recalled in the present description because it does not bring any advantage compared to two single slot vertical DIMM soldered close together, excepted from a manufacturing process point of view which leads to a reduced cost compared to two single slot vertical DIMM socket.

While the invention has been particularly shown and described with reference to a preferred embodiment, it will be understood that various changes in form and detail may be made therein without departing from the spirit, and scope of the invention.

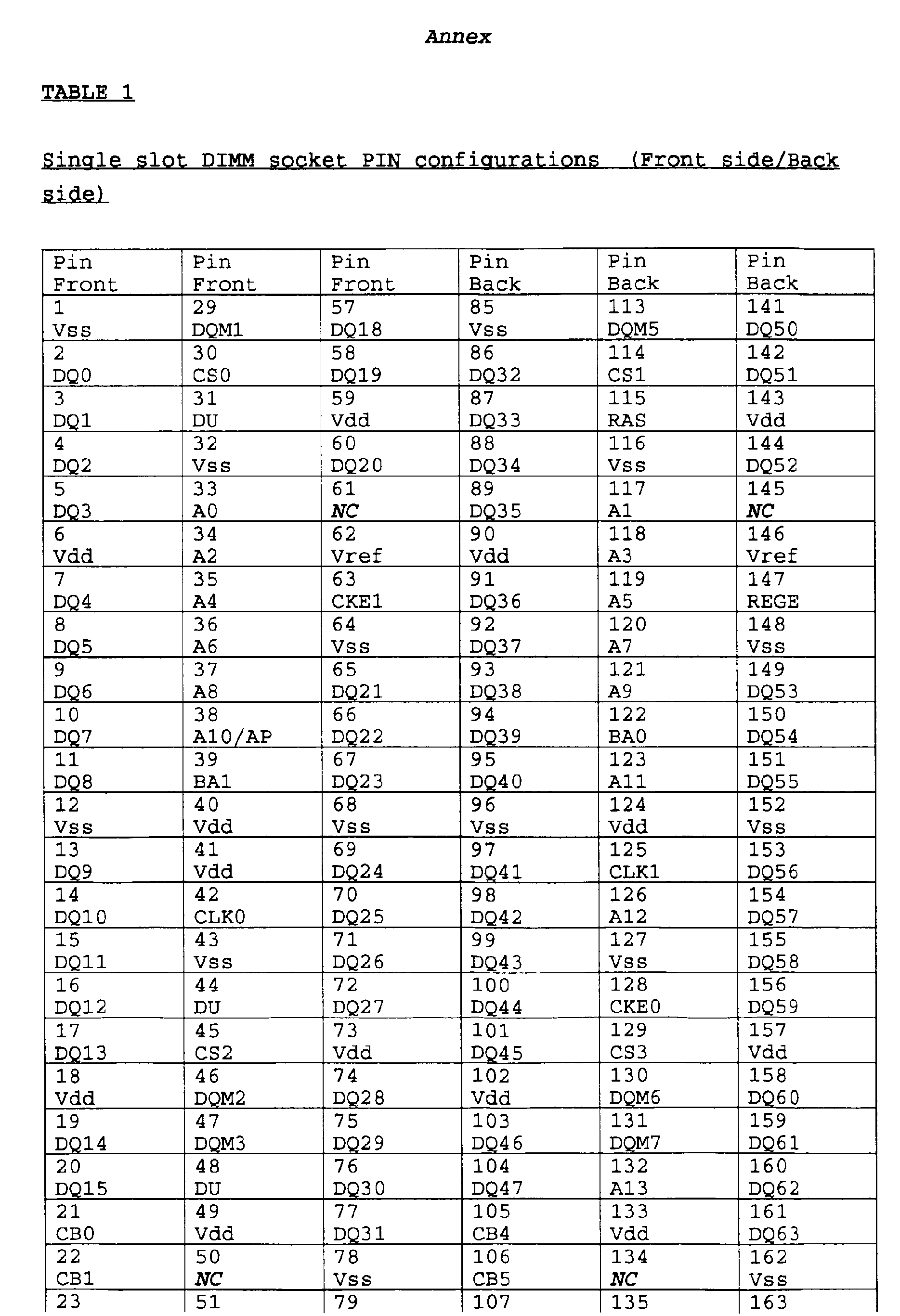

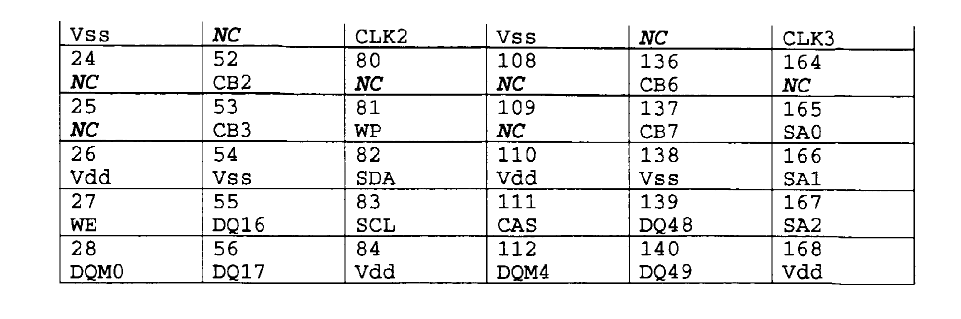

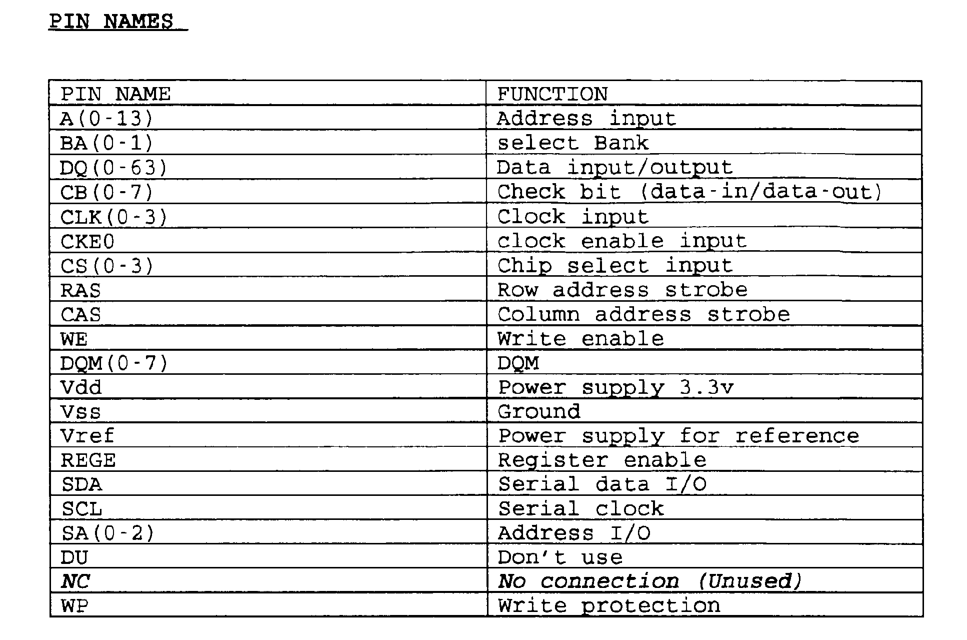

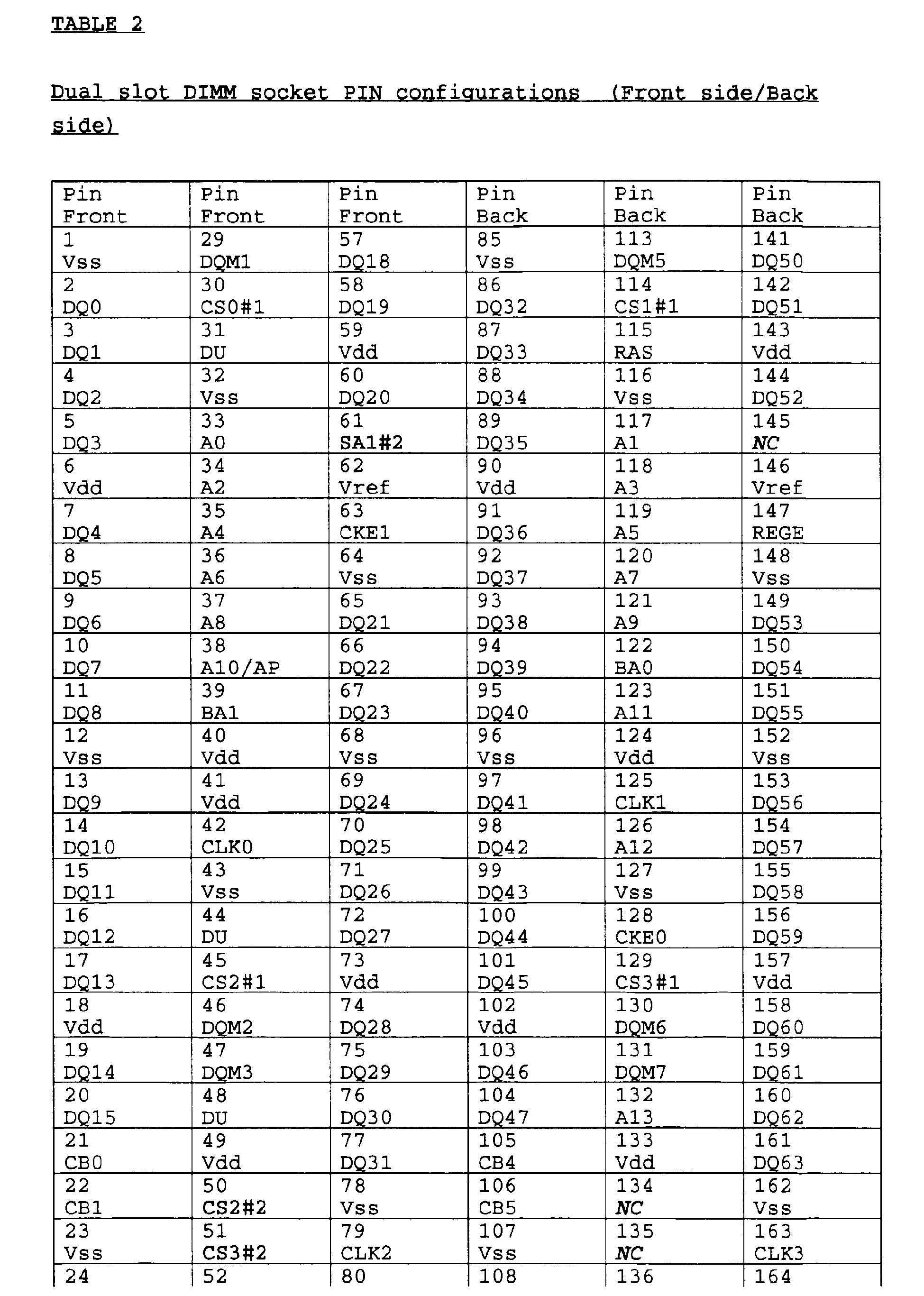

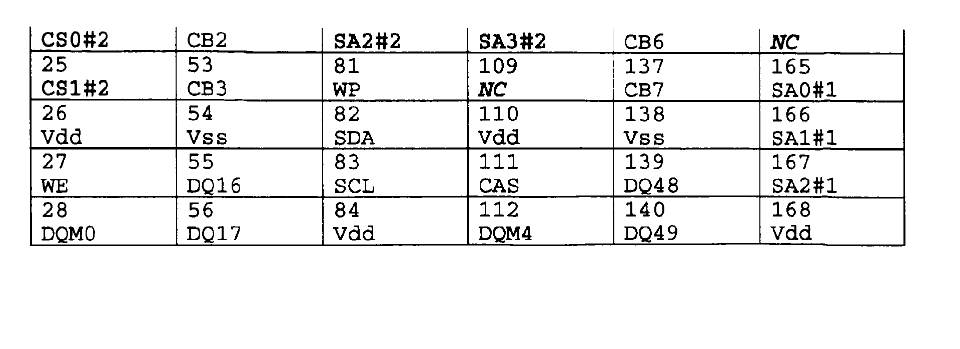

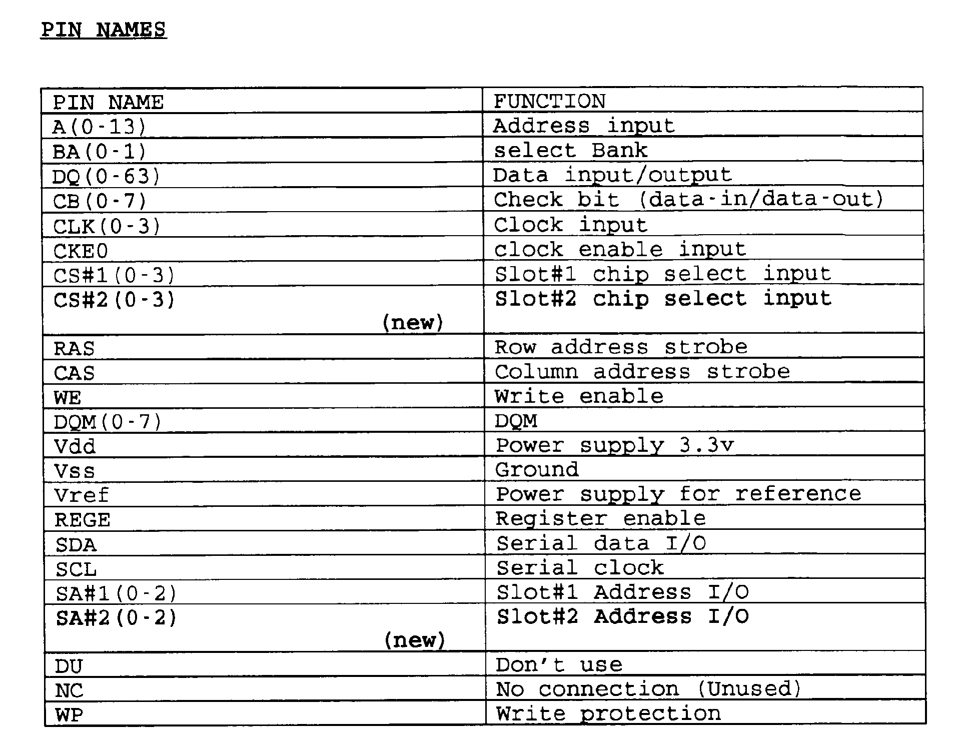

## Claims

1. A socket for connecting a plurality of memory modules on an electronic board, said socket comprising means for connecting said memory modules parallel one another and parallel to the electronic board.

2. The socket according to the preceding claim comprising connecting means for signals common to each memory module and signals specific to each memory module, said specific signals comprising signals for selecting a specific memory module and signals for addressing a serial memory located on each memory module.

3. The socket according to any one of the preceding claims wherein said plurality of memory modules comprise two memory modules.

4. The socket according to any one of the preceding claims wherein memory modules are Dual In Line Memory Modules (DIMMs).

5. The socket according to any one of the preceding claims wherein Dual In Line Memory Modules (DIMMs) are standard 168 contact pins DIMMs.

6. The socket according to any one of the preceding claims wherein the memory is a Dynamic Random Access Memory (DRAM) or a FLASH Random Access Memory (FLASH RAM) or a Static Random Access Memory (SRAM).

7. The socket according to any one of the preceding claims comprising the same footprint than standard socket for single memory module.
